# EUROPEAN PATENT APPLICATION

(11) **EP 4 675 289 A1**
(43) Date of publication of application: **07.01.2026**
(21) Application number: 25306009.9
(22) Date of filing: 30.06.2025
(51) Int. Cl.: G01R 31/327, G01R 31/50, G01R 31/52, H02H 3/33

(54) **DETECTING APPARATUS FOR CIRCUIT BREAKER AND CIRCUIT BREAKER**

(30) Priority: 05.07.2024 CN 202421596539 U
(71) Applicant: SCHNEIDER ELECTRIC INDUSTRIES SAS, 92500 Rueil-Malmaison (FR)
(72) Inventor: TIAN, Jianwei, Shanghai, 201203 (CN); CHEN, Xiaohang, Shanghai, 201203 (CN); SONG, Yangfeng, Shanghai, 201203 (CN); BAI, Wanlong, Shanghai, 201203 (CN); FENG, Jie, Shanghai, 201203 (CN); WANG, Han, Shanghai, 201203 (CN); LU, Feng, Shanghai, 201203 (CN)
(74) Representative: Manitz Finsterwald Patent- und Rechtsanwaltspartnerschaft mbB

(57) **Abstract**

A detecting apparatus for a circuit breaker and a circuit breaker are provided. The detecting apparatus includes: a micro control unit including an analog-to-digital conversion port and a digital-to-analog conversion port; and a zero-sequence current transformer coupled in a line of the circuit breaker and including: an induction coil encircling the line of the circuit breaker; a detection winding coupled to the induction coil and connected to the analog-to-digital conversion port, so as to induce an induction signal from the induction coil at least during a leakage period or a leakage detection period and send a leakage signal related to the induction signal to the analog-to-digital conversion port; and a self-detection winding coupled to the induction coil and connected to the digital-to-analog conversion port, so as to receive a self-detection signal sent by the micro control unit via the digital-to-analog conversion port to perform a leakage detection.

## Description

### FIELD

Example embodiments of the present disclosure generally relate to the field of electrical equipment, and in particular, to a detecting apparatus for a circuit breaker and a circuit breaker.

### BACKGROUND

A residual current operated protective apparatus is an apparatus used to detect a current leakage phenomenon in a circuit and to cut off a power supply in time when the current leakage occurs. It can monitor a leakage current in the circuit, and send a signal when the leakage current exceeds a set value, so as to trigger the circuit to cut off the power supply, thereby protecting the safety of personnel and device.

When a traditional residual current operated protective apparatus performs a self-detection, it causes the circuit breaker in which it is located to be disconnected, thus affecting a power supply of the downstream equipment.

### SUMMARY

**In** a first aspect of the present disclosure, a detecting apparatus for a circuit breaker is provided. The detecting apparatus includes: a micro control unit including an analog-to-digital conversion port and a digital-to-analog conversion port; and a zero-sequence current transformer coupled in a line of the circuit breaker and including: an induction coil encircling the line of the circuit breaker; a detection winding coupled to the induction coil and connected to the analog-to-digital conversion port of the micro control unit, so as to induce an induction signal from the induction coil at least during a leakage period or a leakage detection period and send a leakage signal related to the induction signal to the analog-to-digital conversion port; and a self-detection winding coupled to the induction coil and connected to the digital-to-analog conversion port of the micro control unit, so as to receive a self-detection signal sent by the micro control unit via the digital-to-analog conversion port to perform a leakage detection.

In some embodiments, the zero-sequence current transformer further includes: a sampling resistor coupled to the detection winding and adapted to convert the induction signal into the leakage signal.

In some embodiments, the zero-sequence current transformer further includes: a self-detection resistor coupled to the self-detection winding and adapted to convert the self-detection signal into a self-detection current signal for injection into the induction coil.

In some embodiments, the detecting apparatus further includes a first operational amplifier arranged between the detection winding and the analog-to-digital conversion port.

In some embodiments, the detecting apparatus further includes a second operational amplifier arranged between the self-detection winding and the digital-to-analog conversion port.

In some embodiments, the detecting apparatus further includes an auxiliary power supply coupled to a power supply circuit and adapted to supply power at least to the micro control unit.

In some embodiments, the detecting apparatus further includes a manual detection button coupled to the micro control unit and adapted to be triggered to send a manual detection instruction to the micro control unit.

In some embodiments, the micro control unit further includes: a communication interface adapted to be connected to and communicate with an external device.

According to embodiments of the present disclosure, the detecting apparatus can perform a manually detection on a leakage protection function of the circuit breaker when a user triggers the manual detection button, and can further perform an automatic detection by the micro control unit after a predetermined condition (for example, a predetermined detection cycle is reached) is satisfied. Furthermore, during an automatic detection process, a normal operation of a load on the circuit breaker can be ensured. Thus, the convenience of detection is improved.

In a second aspect of the present disclosure, a circuit breaker is provided. The circuit breaker includes: a line connected between a power supply circuit and a load; at least one solid state switch arranged on the line and adapted to control connection and disconnection of the line; a mechanical switch arranged on the line and adapted to control connection and disconnection of the line; and the detecting apparatus according to the first aspect of the present disclosure, where an induction coil of the detecting apparatus is arranged between the solid state switch and the mechanical switch.

In some embodiments, the solid state switch includes a metal-oxide semiconductor field effect transistor.

In some embodiments, the micro control unit further includes: a first control port coupled to a gate electrode of the metal-oxide semiconductor field effect transistor.

In some embodiments, the micro control unit further includes: a second control port coupled to the mechanical switch to control an action of the mechanical switch.

In some embodiments, the circuit breaker further includes at least one pair of voltage detection elements arranged at two sides of the at least one solid state switch, so as to respectively acquire voltage signals at the two sides of the solid state switch.

In some embodiments, the circuit breaker further includes a pair of sensors respectively arranged at two sides of the solid state switch and the mechanical switch and adapted to detect a current and a voltage of the circuit.

It should be appreciated that what is described in this Summary is not intended to limit critical features or essential features of embodiments of the disclosure, nor is it intended to limit the scope of the disclosure. Other features of the present disclosure will become readily appreciated from the following description.

### Brief Description of the Drawings

The above and other features, advantages, and aspects of various embodiments of the present disclosure will become more apparent with reference to the following detailed description taken in conjunction with the accompanying drawings. In the drawings, the same or similar reference signs denote the same or similar elements, wherein:
FIG. 1 shows a simplified schematic diagram of a circuit breaker according to some embodiments of the present disclosure;
FIG. 2 shows a simplified schematic diagram of a detecting apparatus according to some embodiments of the present disclosure; and
FIG. 3 shows a schematic diagram of a micro control unit controlling the operation of a solid state switch and a mechanical switch according to some embodiments of the present disclosure.

### DETAILED DESCRIPTION

Embodiments of the present disclosure will be described in more detail below with reference to the accompanying drawings. Although certain embodiments of the present disclosure are shown in the accompanying drawings, it should be understood that the present disclosure may be implemented in various forms, and should not be construed as limited to embodiments set forth herein, but rather, these embodiments are provided for a more thorough and complete understanding of the present disclosure. It should be understood that the drawings and embodiments of the present disclosure are only for illustrative purposes and are not intended to limit the scope of the present disclosure.

It should be noted that the title of any section/subsection provided herein is not limiting. Various embodiments are described throughout and any type of embodiments may be included in any section/subsection. Furthermore, embodiments described in any section/subsection may be combined in any manner with any other embodiment described in the same section/subsection and/or in different sections/subsections.

In the description of embodiments of the present disclosure, the terms "including" and the like should be understood as open-ended including, that is, "including but not limited to". The term "based on" should be understood as "based at least in part on". The terms "an embodiment" or "embodiments" should be understood as "at least one embodiment". The term "some embodiments" should be understood as "at least some embodiments". Other explicit and implicit definitions may also be included below. The terms "first", "second", and the like may refer to different or identical objects. Other explicit and implicit definitions may also be included below.

As mentioned briefly above, in conventional residual current operated protective apparatus, a ground fault detection needs to be triggered by a button on a panel. During self-detection , the residual current operated protective apparatus determines whether a fault occurs or not by means of interrupting main circuit, and a downstream electrical device may be affected. In addition, the conventional residual current operated protective apparatus is unable to determine the cause of the fault.

A detecting apparatus for a circuit breaker and a circuit breaker according to the present disclosure are provided to solve or at least partially solve the above described problems and other potential problems existing in the conventional solutions. According to embodiments of the present disclosure, when a current leakage occurs in a circuit, a detection winding may induce an induction signal through an induction coil, and send a leakage signal related to the induction signal to an analog-to-digital conversion port of a micro control unit. After receiving the leakage signal, the micro control unit determines that the intensity of the induction signal exceeds a threshold value, so as to trigger a tripping operation and controls a solid state switch and a mechanical switch in the circuit breaker to be disconnected sequentially.

When it is necessary to detect whether the leakage protection function is normal or not, in response to receiving a manual detection instruction sent after a button is triggered, or to satisfying a self-detection cycle, the micro control unit sends a self-detection signal to the self-detection winding via a digital-to-analog conversion port, and the self-detection winding injects a self-detection current signal into the induction coil after receiving the self-detection signal. At this point, the detection winding, which is also coupled to the induction coil, induces an induction signal from the induction coil and sends a leakage signal related to the induction signal to an analog-to-digital conversion port of the micro control unit. After receiving the leakage signal, the micro control unit determines that the intensity of the induction signal exceeds the threshold value and disconnects the solid state switch.

The micro control unit determines whether the solid state switch is successfully disconnected or not based on voltage signals sent from a pair of voltage detection elements arranged at two sides of the solid state switch. After it is determined that the solid state switch is disconnected, the micro control unit controls the solid state switch to conduct again. Since an action time of the solid state switch from being disconnected to being reconnected is very short (for example, 1 µs), it can be ensured that the electrical device is not affected during the self-detection of the circuit breaker.

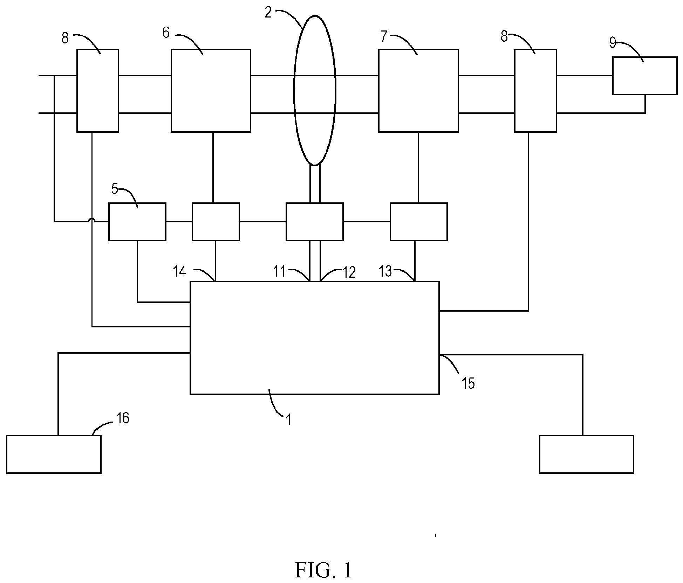

FIG. 1 shows a simplified circuit diagram of a circuit breaker according to some embodiments of the present disclosure. As shown in FIG. 1, the circuit breaker generally includes a line arranged between a power supply circuit and a load 9, a mechanical switch 6 and at least one solid state switch 7 coupled to the line for controlling the connection and disconnection of the line, and a detecting apparatus arranged between the mechanical switch 6 and the solid state switch 7. The detecting apparatus is adapted to control the solid state switch 7 and the mechanical switch 6 to be disconnected successively when a leakage occurs in the line. In addition, the detecting apparatus is further adapted to detect a leakage protection function of the circuit breaker.

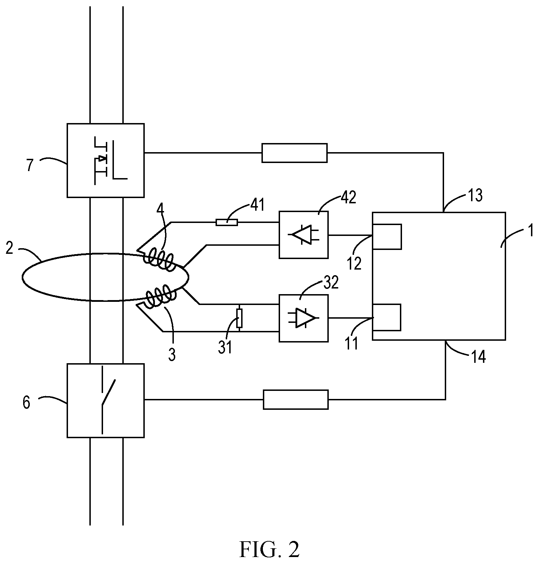

FIG. 2 shows a simplified schematic diagram of the detecting apparatus according to some embodiments of the present disclosure. As shown in FIGS. 1 and 2, the detecting apparatus generally includes a micro control unit (MCU) 1, and a zero-sequence current transformer coupled to a line of a circuit of the circuit breaker. The zero-sequence current transformer includes an induction coil 2, a detection winding 3 and a self-detection winding 4 coupled to the induction coil 2. The detection winding 3 and the self-detection winding 4 are respectively coupled to the control unit. Specifically, the micro control unit 1 includes an analog-to-digital conversion port (ADC) 11 and a digital-to-analog conversion port (DAC) 12. The detection winding 3 is coupled to the analog-to-digital conversion port 11 and is adapted to induce an induction signal from the induction coil 2 at least during a leakage period or a leakage detection period and to send a leakage signal related to the induction signal to the analog-to-digital conversion port 11 of the micro control unit 1. The self-detection winding is coupled to the digital-to-analog converting port 12 of the micro control unit 1 to receive a self-detection signal sent by the micro control unit 1.

In some embodiments, the zero-sequence current transformer further includes a sampling resistor 31. The sampling resistor 31 is connected in parallel at two ends of the detection winding 3. When a current in the induction coil 2 changes (for example, a vector sum of currents of various phases in line passing through the induction coil 2 is not zero), the detection winding 3 induces an induction signal from the induction coil 2, and is converted into a leakage signal through the sampling resistor 31.

In some embodiments, the detecting apparatus further includes a first operational amplifier 32, two ends of the first operational amplifier 32 are respectively connected in parallel at two ends of the sampling resistor 31, and is adapted to perform gain amplification on the leakage signal converted by the sampling resistor 31, and convert the leakage signal into a voltage range signal (for example,0 ~ 3V) suitable for detection by the micro control unit 1, and input gain-amplified leakage signal into the analog-to-digital conversion port 11 of the micro control unit 1 for measurement by the micro control unit 1.

If leakage occurs in the load 9, the induction coil 2 of the circuit breaker detects that leakage current occurs in the line (for example, a vector sum of three-phase currents in the line is not zero), and at this point, an induction signal is induced in the detection winding 3 of the zero-sequence current transformer, and the induction signal is converted into the leakage signal through the sampling resistor 31. Further, after being processed by the first operational amplifier 32, the leakage signal is converted into a voltage range suitable for detection by the micro control unit 1 and then is input into the analog-to-digital conversion port 11 of the micro control unit 1. If the micro control unit 1 detects that the leakage signal exceeds a predetermined threshold value, the micro control unit 1 sends a tripping signal to control the solid state switch 7 and the mechanical switch 6 to be disconnected.

In some embodiments, the zero-sequence current transformer further includes a self-detection resistor 41, where the self-detection resistor 41 is connected to an end of the self-detection winding 4 in series, and is adapted to convert a self-detection signal into a self-detection current signal and inject it into the induction coil 2, so as to cause the induction signal to be induced by the detection winding 3 coupled to the induction coil 2.

In some embodiments, the detecting apparatus further includes a second operational amplifier 42, and the second operational amplifier 42 is connected in series between the self-detection resistor 41 and the digital-to-analog conversion port 12 of the micro control unit 1. The second operational amplifier 42 is coupled to an end of the self-detection resistance 41 away from the self-detection winding.

In some embodiments, the micro control unit 1 further includes a manual detection button 16 adapted to be triggered by a user to send a manual detection instruction to the micro control unit 1. The micro control unit 1 may perform a manual self-detection on the circuit breaker after receiving the manual detection instruction. In some embodiments, the micro control unit 1 may further perform an automatic self-detection on the circuit breaker, and the micro control unit 1 may trigger an automatic detection process when a predetermined self-detection cycle (for example, 5s, 30s, 1min, 15min, 30min, 1h, 2h, 12h, one week, two weeks, or the like) is satisfied.

If a manual detection or an automatic detection on the leakage detection function of the circuit breaker is required, the micro control unit 1 sends the self-detection signal (for example, a sinusoidal voltage of 0V ~ 3V) to the self-detection winding 4 via the digital-to-analog conversion port 12, and the self-detection signal is converted into a leakage voltage signal (for example, a sinusoidal voltage of -3V ~ +3V) suitable for injection into the induction coil 2 through gain transformation of the second operational amplifier 42. After receiving the self-detection signal, the self-detection winding 4 injects the self-detection current signal into the induction coil 2. At this point, the detection winding 3 also coupled to the induction coil 2 induces the induction signal from the induction coil 2, After the induction signal is converted into the leakage signal through the sampling resistor 31, the leakage signal is converted into a voltage signal (for example, 0V~3V) suitable for being received by the micro control unit 1 after being processed by the first operational amplifier 32, and is sent to the analog-to-digital conversion port 11 of the micro control unit 1.

As for the manual detection, after receiving the leakage signal, the micro control unit 1 determines that the intensity of the induction signal exceeds the threshold value and disconnect the solid state switch 7, and subsequently disconnect the mechanical switch 6.

**As** for the automatic detection, after receiving the leakage signal, the micro control unit 1 determines that the intensity of the induction signal exceeds the threshold value and disconnect the solid state switch 7, and after determining that the solid state switch 7 is successfully disconnected within a predetermined time interval (for example, 5 ms), the micro control unit 1 then controls the solid state switch 7 to conduct again. In this way, the detection of the leakage function of the circuit breaker can be realized without the load 9 being powered down.

In some embodiments, the circuit breaker includes at least one solid state switch 7. For example, the at least one solid state switch 7 may include three solid state switches 7, and the solid state switches 7 are respectively arranged in three-phase circuits of the line to respectively control connection and disconnection of the three-phase circuits.

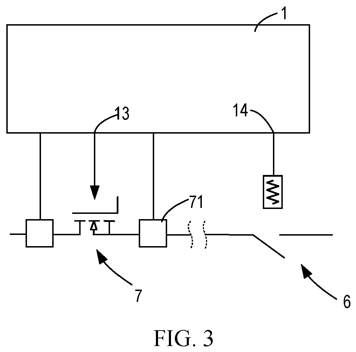

FIG. 3 shows a schematic diagram of the micro control unit 1 controlling the operation of the solid state switch 7 and the mechanical switch 6 according to some embodiments of the present disclosure. As shown in FIG. 3, in some embodiments, the micro control unit 1 includes a first control port 13 coupled to a control side of the solid state switch 7, and the micro control unit 1 may send a control signal to the solid state switch 7 through the first control port 13, so as to control the solid state switch 7 to be connected or disconnected.

In some embodiments, the solid state switch 7 may include a metal-oxide semiconductor field effect transistor. A source electrode and a drain electrode of the metal-oxide semiconductor field effect transistor are respectively coupled to the line, and a gate electrode of the metal-oxide semiconductor field effect transistor is coupled to the first control port 13 of the micro control unit 1. The micro control unit 1 may output the control signal to the solid state switch 7 through the first control port 13, thereby controlling the solid state switch 7 to be connected or disconnected.

In some embodiments, the circuit breaker further includes at least one pair of voltage detection elements 71. The at least one pair of voltage detection elements 71 are respectively coupled to two ends of the at least one solid state switch 7, for example, a pair of voltage detection elements 71 are respectively coupled to the source electrode and the drain electrode of the metal-oxide semiconductor field effect transistor. The micro control unit 1 may detect voltages at two sides of the solid state switch 7 for a period of time (for example, 5 ms) after the solid state switch 7 performs an action through the pair of voltage detection elements 71, thereby determining whether the solid state switch 7 acts or not. For example, when the micro control unit 1 sends the control signal and controls the solid state switch 7 to be disconnected. If the micro control unit 1 detects a voltage change between two sides of the solid state switch 7 (for example, when the solid state switch 7 is connected, the voltage difference between the two sides is zero, and after the solid state switch 7 is disconnected, there is a voltage difference between the two sides), it can be determined that the solid state switch 7 has successfully completed the action.

In some embodiments, the mechanical switch 6 may include a coil (or electromagnet) for controlling the mechanical switch 6 to be opened (disconnected) or be closed (connected). In some embodiments, the micro control unit 1 further includes a second control port 14 coupled to the coil of the mechanical switch 6 and adapted to control the mechanical switch 6 to be connected or disconnected by controlling the operation of the coil.

When performing a tripping command, the micro control unit 1 may control the solid state switch 7 to be disconnected first, and after the micro control unit 1 determines that the solid state switch 7 is successfully disconnected, the micro control unit 1 controls the mechanical switch 6 to be disconnected via the second control port 14. Similarly, during the period in which the micro control unit 1 controls the circuit breaker to be closed, the micro control unit 1 may first control the mechanical switch 6 to be closed, and then control the solid state switch 7 to be closed. In this way, it is possible to reduce an arc generated by the mechanical switch 6 during action, thereby improving the safety of the operation of the circuit breaker while prolonging the service life of the circuit breaker.

When self-detection or remotely commanding the solid state switch 7 to perform a disconnection command, the solid state switch 7 can be disconnected when the current passes through zero, so as to prolong the life of the solid state switch; when the tripping command is need to be performed due to the occurrence of leakage, the solid-state switch 7 does not need to pass through zero and performs immediately.

In some embodiments, the detection apparatus further includes an auxiliary power source 5 coupled to the power supply circuit and adapted to supply power at least to the micro control unit 1. In some embodiments, the auxiliary power source 5 is further adapted to supply power to the control module of the mechanical switch 6 and/or the solid state switch 7, so that the corresponding control module can drive the mechanical switch 6 and/or the solid state switch 7 to act (e. g., disconnection or connection).

In some embodiments, the micro control unit 1 further includes a communication interface 15, and the communication interface 15 is suitable for being connected to an external device, such that the external device can acquire information stored in the micro control unit 1 (e. g. action information of various elements during tripping) and/or load or modify configuration information to the micro control unit 1 via the communication interface 15. In some embodiments, if the circuit breaker detects that the leakage protection function is faulty, the circuit breaker may further report data such as a fault parameter and/or a fault cause to a remote host through the communications interface 15.

In some embodiments, the circuit breaker further includes a pair of sensors 8 respectively arranged at two sides of the solid state switch 7 and the mechanical switch 6, and adapted to detect a current and a voltage of the line.

How the circuit breaker performs manual self-detection and automatic self-detection will be described below with reference to various embodiments.

As for manual self-detection, in some embodiments, after the user presses the manual detection button 16, the manual detection button 16 sends a manual detection instruction to the micro control unit 1. After receiving the manual detection instruction, the micro control unit 1 sends a self-detection signal (for example, a sinusoidal signal of 0V∼3V) to the self-detection winding 4, the self-detection signal is converted into a voltage signal (for example, a sinusoidal signal of -3V ~ +3V) suitable for injection into the self-detection winding 4 after being processed by the second operational amplifier 42, and the voltage signal is converted into a corresponding current signal through the self-detection resistor 41 and is input into the self-detection winding 4. At this point, the detection winding 3 induces, through the induction coil 2, current fluctuation of the self-detection winding 4, so as to generate an induction signal (for example, an induction current), where the induction signal is converted into a leakage signal (for example, an induction voltage related to the induction current) through the sampling resistor 31. After being processed by the first operational amplifier 32, the leakage signal is converted into a voltage signal (for example, 0V ~ 3V) suitable for being received by the micro control unit 1, and is input into the micro control unit 1 through the analog-to-digital conversion port 11. When detecting that the leakage signal is greater than a predetermined threshold value, the micro control unit 1 controls the solid state switch 7 to be disconnected, and controls the mechanical switch to be disconnected after the solid state switch 7 is successfully disconnected.

As for automatic self-detection, in some embodiments, when the micro control unit 1 satisfies a predetermined cycle (for example, 12h) of automatic self-detection, the micro control unit 1 sends a self-detection signal (for example, a sinusoidal signal of 0V ~ 3V) to the self-detection winding 4, and the self-detection signal is converted into a voltage signal (for example, a sinusoidal signal of -3 ~+3V) suitable for injection into the self-detection winding 4 after being processed by the second operational amplifier 42. The voltage signal is converted into a corresponding current signal through the self-detection resistor 41, and is input into the self-detection winding 4. At this point, the detection winding 3 induces the current fluctuation of the self-detection winding 4 through the induction coil 2, so as to generate an induction signal (for example, an induction current). The induction signal is converted to a leakage signal (e.g., an induction voltage related to the induction current) via the sampling resistor 31. After being processed by the first operational amplifier 32, the leakage signal is converted into a voltage signal (for example, 0V ~ 3V)suitable for being received by the micro control unit 1, and is input into the micro control unit 1 through the analog-to-digital conversion port 11. The micro control unit 1 controls the solid state switch 7 to be disconnected when detecting that the leakage signal is greater than a predetermined threshold value, and the micro control unit 1 recontrols the solid state switch 7 to be connected within a certain time interval after determining that the solid state switch 7 is successfully disconnected. Since the time interval of the solid state switch 7 from being disconnected to being connected is very short during the automatic detection process (for example, it takes 5 ms to determine whether the solid state switch 7 acts or not and it takes 1 µs for the solid state switch to perform a closing action), therefore the load 9 connected to the circuit breaker will not be de-energized.

In some embodiments, in order to ensure that the micro control unit 1 can accurately receive the leakage signal related to the detection signal, the intensity of the detection current injected into the detection winding 3 may be greater than or equal to two times the rated residual current. In this way, even if a residual current opposite to the detection current exists in the line, after the detection current cancels out the residual current, there is still detection current left, which is sufficient to be detected by the micro control unit 1, to be induced by the detection winding 3.

In some embodiments, due to a delay in the induction of the detection winding 3, there is a phase difference φ in actually detected current. Therefore, the micro control unit 1 may be calibrated before using the circuit breaker, so as to reduce errors.

In some embodiments, the micro control unit 1 may further diagnose a position of the fault in the circuit breaker according to action parameters of various elements.

For example, during the manual detection process, the circuit breaker does not trip. If the micro control unit 1 only detects a detection signal of 1.5V, at this point, it may be determined that the induction coil 2 is faulty.

During the manual detection process, the circuit breaker does not trip. If the micro control unit 1 does not detect the detection signal, at this point, it may be determined that the circuit between the detection winding 3 and the micro control unit 1 is faulty.

During the manual detection process, the circuit breaker does not trip. If the micro control unit 1 detects the detection signal and detects that a voltage of the auxiliary power source 5 is abnormal (for example, less than 10 V) at the same time. At this point, it may be determined that the auxiliary power source 5 and/or the relevant circuit is faulty.

During the manual detection process, the circuit breaker does not trip. If the micro control unit 1 detects the detection signal and detects that the voltage of the auxiliary power source 5 is normal (for example, 13V), the micro control unit 1 does not receive a feedback signal related to an contact action of the mechanical switch 6, and at this point, it may be determined that the coil (or electromagnet) used for driving the mechanical switch 6 to act is faulty.

During the manual detection process, the circuit breaker does not trip. If the micro control unit 1 detects the detection signal and detects that the voltage of the auxiliary power source 5 is normal (for example, 13V), the feedback signal received by the micro control unit 1 related to contact action of the mechanical switch 6 is incomplete. At this point, it may be determined that the mechanical switch 6 is faulty.

During the automatic detection process, if the residual current corresponding to the detection signal detected by the micro control unit 1 is less than a rated residual current, and the micro control unit 1 only detects a detection signal of 1.5V. At this point, it may be determined that the induction coil 2 is faulty.

During the automatic detection process, if the residual current corresponding to the detection signal detected by the micro control unit 1 is less than the rated residual current, and the micro control unit 1 cannot detect the detection signal, at this point, it may be determined that the circuit between the detection winding 3 and the micro control unit 1 is faulty .

During the automatic detection process, if the residual current corresponding to the detection signal detected by the micro control unit 1 is less than the rated residual current, and the micro control unit 1 fails to perform a solid state switch-related action (from connected->disconnected->connected) or the voltage of the auxiliary power source 5 is abnormal, at this point, it may be determined that the auxiliary power source 5 and/or the relevant circuit is faulty.

Embodiments of the present disclosure have been described above, and the above description is illustrative, not exhaustive, and is not limited to the disclosed embodiments. Many modifications and variations will be apparent to those of ordinary skill in the art without departing from the scope and spirit of the illustrated embodiments. The selection of terms as used herein is intended to best explain the principles of the embodiments, the practical application or technical improvements to the market, or to enable others of ordinary skill in the art to understand the embodiments disclosed herein.

## Claims

1. A detecting apparatus for a circuit breaker, **characterized by** comprising:
a micro control unit (1) comprising an analog-to-digital conversion port (11) and a digital-to-analog conversion port (12); and
a zero-sequence current transformer coupled in a line of the circuit breaker and comprising:
an induction coil (2) encircling the line of the circuit breaker;
a detection winding (3) coupled to the induction coil (2) and connected to the analog-to-digital conversion port (11) of the micro control unit (1), so as to induce an induction signal from the induction coil (2) at least during a leakage period or a leakage detection period and send a leakage signal related to the induction signal to the analog-to-digital conversion port (11); and
a self-detection winding (4) coupled to the induction coil (2) and connected to the digital-to-analog conversion port (12) of the micro control unit (1), so as to receive a self-detection signal sent by the micro control unit (1) via the digital-to-analog conversion port (12) to perform a leakage detection.

2. The detecting apparatus according to claim 1, **characterized in that** the zero-sequence current transformer further comprises:
a sampling resistor (31) coupled to the detection winding (3) and adapted to convert the induction signal into the leakage signal.

3. The detecting apparatus according to any of claims 1 to 2, **characterized in that** the zero-sequence current transformer further comprises:
a self-detection resistor (41) coupled to the self-detection winding (4) and adapted to convert the self-detection signal into a self-detection current signal for injection into the induction coil (2).

4. The detecting apparatus according to any of claims 1 to 3, **characterized by** further comprising a first operational amplifier (32) arranged between the detection winding (3) and the analog-to-digital conversion port (11).

5. The detecting apparatus according to any of claims 1 to 4, **characterized by** further comprising a second operational amplifier (42) arranged between the self-detection winding (4) and the digital-to-analog conversion port (12).

6. The detecting apparatus according to any of claims 1 to 5, **characterized by** further comprising an auxiliary power supply (5) coupled to a power supply circuit and adapted to supply power at least to the micro control unit (1).

7. The detecting apparatus according to any of claims 1 to 6, **characterized by** further comprising a manual detection button (16) coupled to the micro control unit (1) and adapted to be triggered to send a manual detection instruction to the micro control unit (1).

8. The detecting apparatus according to any of claims 1 to 6, **characterized in that** the micro control unit (1) further comprises:
a communication interface (15) adapted to be connected to and communicate with an external device.

9. A circuit breaker, **characterized by** comprising:
a line connected between a power supply circuit and a load (9);
at least one solid state switch (7) arranged on the line and adapted to control connection and disconnection of the line;
a mechanical switch (6) arranged on the line and adapted to control connection and disconnection of the line; and
the detecting apparatus according to any of claims 1 to 8, wherein an induction coil (2) of the detecting apparatus is arranged between the solid state switch (7) and the mechanical switch (6).

10. The circuit breaker according to claim 9, **characterized in that** the solid state switch (7) comprises a metal-oxide semiconductor field effect transistor.

11. The circuit breaker according to claim 10, **characterized in that** the micro control unit (1) further comprises: a first control port (13) coupled to a gate electrode of the metal-oxide semiconductor field effect transistor.

12. The circuit breaker according to any of claims 9 to 11, **characterized in that** the micro control unit (1) further comprises: a second control port (14) coupled to the mechanical switch (6) to control an action of the mechanical switch (6).

13. The circuit breaker according to any of claims 9 to 12, **characterized by** further comprising at least one pair of voltage detection elements (71) arranged at two sides of the at least one solid state switch (7), so as to respectively acquire voltage signals at the two sides of the solid state switch (7).

14. The circuit breaker according to any of claims 9 to 13, **characterized by** further comprising a pair of sensors (8) respectively arranged at two sides of the solid state switch (7) and the mechanical switch (6) and adapted to detect a current and a voltage of the circuit.
